# EUROPEAN PATENT APPLICATION

(11) **EP 4 343 022 A2**
(43) Date of publication of application: **27.03.2024**
(21) Application number: 22216723.1
(22) Date of filing: 27.12.2022
(51) Int. Cl.: C23C 16/44, C23C 16/54, C23C 16/46, C23C 16/48, C23C 16/02, B05D 1/00, C23C 16/448

(54) **ADHESION IMPROVEMENT PRETREATMENT SYSTEM AND METHOD USING THE SAME**

(30) Priority: 28.12.2021 KR 20210189480
(71) Applicant: Korea Aerospace Research Institute, Daejeon 34133 (KR); Korea Space Technology Co., Ltd., Daejeon 34365 (KR); Obang Technology Co., Ltd., Gyeonggi-do 10045 (KR)
(72) Inventor: KIM, You gwang, 30126 Sejong-si (KR); LEE, Chang-soo, 17035 Gyeonggi-do (KR); BAE, Sangkyun, 10046 Gyeonggi-do (KR)
(74) Representative: dompatent von Kreisler Selting Werner - Partnerschaft von Patent- und Rechtsanwälten mbB

(57) **Abstract**

The present invention relates to a pretreatment system and a method using the pretreatment system, and more particularly, to a pretreatment system in which adhesion between a base material and a coating material is improved by pretreating a part to be coated, and a method using the pretreatment system. The present invention may improve the contact force (adhesive force) between the product to be coated and the parylene thin film and performing pretreatment regardless of a material type of base material, and shortening the time of a coating process.

## Description

### [Technical Field]

The present invention relates to a pretreatment system and a method using the pretreatment system, and more particularly, to a pretreatment system in which adhesion between a base material and a coating material is improved by pretreating a part to be coated, and a method using the pretreatment system.

### [Background Art]

In a coating process of vaporizing a powdered raw material and depositing the material in the form of gas in a chamber to form a parylene thin film and insulate a base material, in order for the base material and a coating raw material to adhere to each other with uniform and high adhesive strength, the need for a technology of increasing the adhesion of a surface of the base material has emerged.

Accordingly, a technology of converting the raw material from a dimer state to a monomal state by high-temperature pyrolysis and surface treating the raw material with a plasma method before coating the raw material on the surface of the base material has been proposed, but in the case of such a plasma method, there were problems in that a separate plasma generating apparatus was required, production efficiency was reduced due to high equipment price, and space for disposing the plasma generating apparatus was also required.

Accordingly, a technology of coating the surface of the base material with a pretreatment solution to increase adhesion has been proposed, and among these, an apparatus for directly attaching an apparatus for receiving, vaporizing, and spraying the pretreatment solution into a chamber to the chamber has been proposed (Korean Publication Patent No. 10-2008-0085542 "Vaporizer for Semiconductor Manufacturing", hereinafter referred to as the prior art), but, in the case where the base material exists by polymerizing several materials, when the base material includes a material that does not require vaporization of the pretreatment solution, there was a problem in that the pretreatment is not easy because it is difficult to respond flexibly.

Accordingly, a method of directly dipping the base material in the pretreatment solution has been proposed, but when a liquid pretreatment solution is directly dipped into the base material, there was a problem in that the liquid pretreatment solution may not be uniformly applied to the element (ex> PCB) or the surface of the base material.

### [Prior Art Document]

### [Patent Document]

Korean Publication Patent No. 10-2008-0085542 (Vaporizer for Semiconductor Manufacturing)

### [Disclosure]

### [Technical Problem]

An object of the present invention is to provide an adhesion improvement pretreatment system that further includes a coating chamber in which a vacuum pump and a trap apparatus are coupled to perform vacuum adsorption coating and a pretreatment chamber separated from the coating chamber, and includes a vaporizer vaporizing and applying a pretreatment solution to the pretreatment chamber and a heating unit heating the pretreatment chamber, thereby improving the contact force (adhesive force) between the product to be coated and the parylene thin film and performing pretreatment regardless of a material type of base material, and shortening the time of a coating process, and a method using the adhesion improvement pretreatment system.

In addition, an object of the present invention is to provide an adhesion improvement pretreatment system that further includes a coating chamber in which a vacuum pump and a trap apparatus are coupled to perform vacuum adsorption coating and a pretreatment chamber integrally formed with the coating chamber, and includes a vaporizer vaporizing and applying a pretreatment solution to the pretreatment chamber and a heating unit heating the pretreatment chamber, thereby improving the contact force (adhesive force) between the product to be coated and the parylene thin film and performing pretreatment regardless of a material type of base material, and increasing the efficiency of a space where the system is placed, and a method using the adhesion improvement pretreatment system.

### [Technical Solution]

An adhesion improvement pretreatment system according to an embodiment of the present invention includes a coating chamber in which a space is formed therein, and a coating material is coated on a surface by applying heat and vacuum to a base material, a pretreatment unit increasing an adhesion of a surface of the base material by applying a pretreatment material that increases the adhesion to the surface of the base material, a vacuum pump maintaining an inside of the coating chamber in a vacuum state by sucking inside air of the coating chamber, a trap apparatus disposed between the vacuum pump and the coating chamber and collecting at least one of a pretreatment material and the coating material in the inside air, and a control unit controlling at least one of the coating chamber or the pretreatment unit.

The pretreatment unit includes a pretreatment chamber in which a space is formed therein, the pretreatment material is coated on the surface of the base material, and integrally formed with the coating chamber, and a heating unit increasing an adhesion between the pretreatment material and the surface of the base material by applying heat to the base material.

The pretreatment chamber is formed integrally with the coating chamber.

The heating unit is a heater attached to an inner surface or an outer surface of the coating chamber and directly applying heat to the coating chamber.

The heating unit is a heater rod interpolated into the coating chamber and rotating in an extension direction, and a reflector reflecting heat of the heater rod to the entire inside of the coating chamber.

The pretreatment unit further includes a rotation unit interpolated into the coating chamber and coupled to the base material to rotate the base material, and the rotation unit includes a rotation plate to which the base material is coupled and a rotation shaft rotating the rotation plate.

The pretreatment unit further includes a vaporization unit that exists separately from the coating chamber, vaporizes the pretreatment material by applying heat to the pretreatment material, and injects the vaporized pretreatment material into the coating chamber.

The pretreatment chamber is provided independently outside the coating chamber, and has the heating unit embedded therein.

The pretreatment unit further includes a vaporization unit provided on the outside the coating chamber, vaporizing the pretreatment material by applying heat to the pretreatment material, and injecting the vaporized pretreatment material into the coating chamber.

The pretreatment unit further includes a pretreatment vacuum pump maintaining an inside of the pretreatment chamber in a vacuum state by sucking inside air of the pretreatment chamber, and a pretreatment trap apparatus disposed between the pretreatment vacuum pump and the pretreatment chamber and collecting the pretreatment material in the inside air of the pretreatment chamber.

The adhesion improvement pretreatment system further includes a vacuum sensor attached to at least one of the coating chamber and the pretreatment chamber, and measuring a degree of internal vacuum of any one of the coating chamber or the pretreatment chamber, each of the coating chamber and the pretreatment chamber includes a vacuum release valve injecting outside air into the inside, and, when the degree of vacuum measured by the vacuum sensor is less than a predetermined numeral value, the control unit closes the vacuum release valve, and actuates at least one of the vacuum pump or the pretreatment vacuum pump.

The adhesion improvement pretreatment system further includes a temperature sensor attached to at least one of the coating chamber or the pretreatment chamber and measuring an internal temperature of any one of the coating chamber or the pretreatment chamber, and when the temperature measured by the temperature sensor is less than a predetermined numerical value, the control unit drives the heating unit.

The adhesion improvement pretreatment system further includes a raw material treatment unit connected to the coating chamber, receiving the coating material from the coating chamber, and decomposing and treating the coating material.

An adhesion improvement pretreatment method using an adhesion improvement pretreatment system according to an embodiment of the present invention includes, by a control unit, (a) vaporizing a pretreatment material by applying heat to a pretreatment material through a vaporization unit of a pretreatment unit, (b) pretreating a base material by applying the pretreatment material to a surface of the base material through the pretreatment unit, (c) vacuum adsorbing the coating material and the base material through a coating chamber, and (d) receiving and treating a remaining coating material from the coating chamber through a raw material treatment unit.

Step (b) includes, by the control unit, (b1) closing a vacuum release valve and actuating a vacuum pump to make an inside the coating chamber in a vacuum state, (b2) applying heat to the coating chamber by operating a heating unit, and (b3) removing the remaining pretreatment material inside the coating chamber.

The heating unit is a heater attached to an inner surface or an outer surface of the coating chamber and directly applying heat to the coating chamber.

The heating unit is a heater rod interpolated into the coating chamber and rotating in an extension direction.

Step (b) includes, by the control unit, (b4) closing a vacuum release valve and actuating a pretreatment vacuum pump to make an inside of a pretreatment chamber in a vacuum state, and (b5) applying heat to the pretreatment chamber by driving a heating unit.

The adhesion improvement pretreatment method further includes, between step (b) and step (c), (e) base material transfer step of moving the base material inside the pretreatment chamber into the coating chamber.

### [Advantageous Effects]

The adhesion improvement pretreatment system and the method using the adhesion improvement pretreatment system according to the present invention described above may further include a coating chamber in which a vacuum pump and a trap apparatus are coupled to perform vacuum adsorption coating and a pretreatment chamber separated from the coating chamber, and include a vaporizer vaporizing and applying a pretreatment solution to the pretreatment chamber and a heating unit heating the pretreatment chamber, thereby improving the contact force (adhesive force) between the product to be coated and the parylene thin film and performing pretreatment regardless of a material type of base material, and shortening the time of a coating process.

In addition, the adhesion improvement pretreatment system and the method using the adhesion improvement pretreatment system may further include a coating chamber in which a vacuum pump and a trap apparatus are coupled to perform vacuum adsorption coating and a pretreatment chamber integrally formed with the coating chamber, and include a vaporizer vaporizing and applying a pretreatment solution to the pretreatment chamber and a heating unit heating the pretreatment chamber, thereby improving the contact force (adhesive force) between the product to be coated and the parylene thin film and performing pretreatment regardless of a material type of base material, and increasing the efficiency of a space where the system is placed.

### [Description of Drawings]

FIG. 1 is a schematic diagram showing a first embodiment of an adhesion improvement pretreatment system of the present invention.
FIG. 2 is a schematic diagram showing the first embodiment of the adhesion improvement pretreatment system of the present invention.
FIG. 3 is a schematic diagram showing the first embodiment of the adhesion improvement pretreatment system of the present invention.
FIG. 4 is a flowchart illustrating an adhesion improvement pretreatment method of the present invention.
FIG. 5 is a flowchart illustrating detailed steps of a pretreatment step according to a first embodiment of an adhesion improvement pretreatment method of the present invention.
FIG. 6 is a flowchart illustrating a second embodiment of an adhesion improvement pretreatment method of the present invention.
FIG. 7 is a flowchart illustrating detailed steps of a pretreatment step according to the second embodiment of the adhesion improvement pretreatment method of the present invention.

### [Best Mode]

Hereinafter, the technical idea of the present invention will be described in more detail using the accompanying drawings. Prior to this, the terms or words used in the present specification and claims should not be construed as being limited to the usual or dictionary meaning, and should be interpreted as a meaning and concept consistent with the technical idea of the present invention based on the principle that the inventor may appropriately define the concept of the term in order to explain his/her invention in the best way.

Hereinafter, the basic configuration of an adhesion improvement pretreatment system 1000 of the present invention will be described.

The present invention may include a coating chamber 100 in which a space is formed therein, and a coating material is coated on the surface by applying heat and vacuum to a base material. At this time, the coating material may be a sealant forming a parylene thin film. The inside of the coating chamber 100 is preferably maintained in a vacuum state, and the base material may be coated with a coating material in a vaporized state by receiving heat. At this time, it is preferable to maintain a constant degree of vacuum even when a coating material in a gas state is introduced. At this time, the temperature of the coating chamber 100 is preferably maintained within 200 degrees Celsius, and the temperature of the coating chamber 100 is preferably maintained according to a surface material of the base material. A specific temperature and a control method of a degree of vacuum will be described below.

In addition, the present invention may include a vacuum pump 400 maintaining the inside of the coating chamber 100 in the vacuum state by sucking inside air of the coating chamber 100 and a trap apparatus 500 disposed between the vacuum pump 400 and the coating chamber 100 and collecting at least one of a pretreatment material and the coating material in the inside air. The vacuum pump 400 may make the inside of the coating chamber 100 in the vacuum state, and maintain the coating chamber 100 in the vacuum state, thereby increasing coating efficiency. The trap apparatus 500 may contain oil capable of collecting the coating material therein, and when the inside air of the coating chamber 100 is sucked by the vacuum pump 400, the inside air of the coating chamber 100 contacts the internal oil of the trap apparatus 500, and thus, the remaining coating material in the vaporized state contained in the air may react with the oil and may be instantly cooled and collected. By including such a configuration, the residual coating material may be introduced into the vacuum pump 400, and thus, failure of the vacuum pump 400 may be prevented, and furthermore, the lifespan of the adhesion improvement pretreatment system 1000 of the present invention may be increased.

At this time, furthermore, the coating chamber 100 may include a main valve 120 provided on a flow path connected to the vacuum pump 400 and the trap apparatus 500 and the coating chamber 100. The main valve 120 may be controlled by a control unit 300 to be described below, may be a ball valve type, and may be driven by receiving power.

In addition, the coating chamber 100 may further include a vacuum release valve releasing an internal vacuum by injecting outside air into the coating chamber 100. The vacuum release valve may be controlled by the control unit 300 to be described below, and the control unit 300 may open the vacuum release valve when releasing the vacuum in the coating chamber 100. The vacuum release valve may be a solenoid type and may be actuated by receiving power.

In addition, the adhesion improvement pretreatment system 1000 of the present invention may include a pretreatment unit 200 increasing the adhesion of the surface of the base material by applying a pretreatment material that increases the adhesion to the surface of the base material, and the pretreatment unit 200 preferably includes a pretreatment chamber 210 in which a space is formed therein, and a pretreatment material is coated on the surface of the base material and a heating unit 230 increasing an adhesion between the pretreatment material and the surface of the base material by applying heat to the base material. By including the pretreatment unit 200, the adhesion of the surface of the base material may be improved in the coating process between the base material and the coating material made in the coating chamber 100.

In addition, the adhesion improvement pretreatment system 1000 of the present invention may include the control unit 300 controlling at least one of the coating chamber 100 and the pretreatment unit 200. The control unit 300 may control the main valve 120 and the vacuum release valve included in the coating chamber 100 of the present invention, and adjust the condition of pretreatment according to the material of the base material (e.g., whether or not there is pretreatment, whether or not the pretreatment solution is vaporized, whether or not heat treatment is performed during pretreatment or coating, etc.) by controlling the pretreatment unit 200, and accordingly, the adhesion of the surface of the base material may be improved with maximum efficiency.

In addition, the adhesion improvement pretreatment system 1000 of the present invention may further include a raw material treatment unit 600 connected to the coating chamber 100, receiving the coating material from the coating chamber 100, and decomposing and treating the coating material. Two or more raw material treatment units 600 may be included, one side of the raw material treatment unit 600 is preferably connected to the coating chamber 100, and the other side of the raw material treatment unit 600 is connected to the outside so that raw material treated air may be exhausted to the outside.

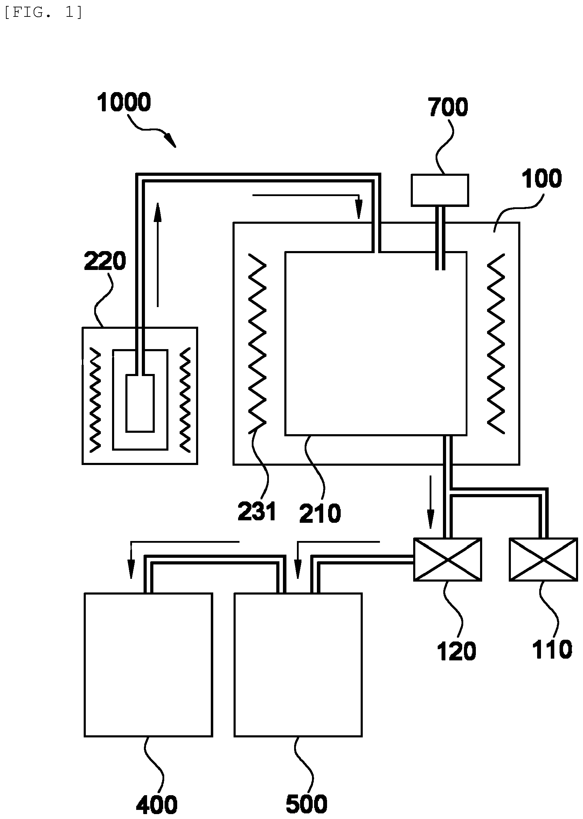

Hereinafter, referring to FIG. 1, a first embodiment of the adhesion improvement pretreatment system 1000 according to the present invention will be described.

In the first embodiment of the adhesion improvement pretreatment system 1000 of the present invention shown in FIG. 1, the pretreatment unit 200 preferably includes the pretreatment chamber 210 integrally formed with the coating chamber 100. In addition, the heating unit 230 is preferably a heater 231 attached to an inner surface or an outer surface of the coating chamber 100 and directly applying heat to the coating chamber 100. In addition, the pretreatment unit 200 preferably further includes a vaporization unit 220 that exists separately from the coating chamber 100, vaporizes the pretreatment material by applying heat to the pretreatment material, and injects the vaporized pretreatment material into the coating chamber 100.

In more detail, in a state where the inside of the coating chamber 100 is maintained in the vacuum state, preferably, the pretreatment solution is vaporized by the vaporization unit 220 and introduced into the coating chamber 100, the pretreatment material may be deposited on the surface of the base material by heating the inside of the coating chamber 100 by the heater 231, after deposition is completed, the inside air of the coating chamber 100 is introduced into the trap apparatus 500 by opening the vacuum release valve and the main valve 120, and the trap apparatus 500 collects the remaining pretreatment material in the vaporized state. Accordingly, the remaining pretreatment material inside the coating chamber 100 may be removed. Thereafter, preferably, the coating material in the vaporized state is applied in the coating chamber 100 and is coated on the surface of the base material.

By adopting the first embodiment of the adhesion improvement pretreatment system 1000 of the present invention, it is possible to perform both the pretreatment process and the coating process in one chamber, thereby increasing the efficiency of space and reducing the cost required for equipment.

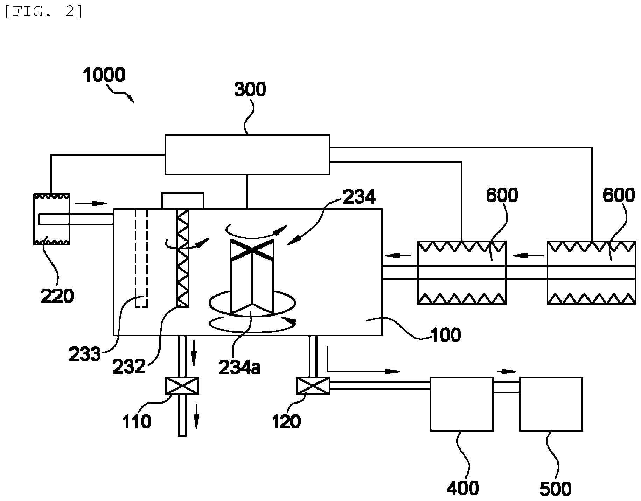

Hereinafter, referring to FIG. 2, a second embodiment of the adhesion improvement pretreatment system 1000 of the present invention will be described.

In the second embodiment of the adhesion improvement pretreatment system 1000 of the present invention shown in FIG. 2, the pretreatment unit 200 preferably includes the pretreatment chamber 210 integrally formed with the coating chamber 100. In addition, the heating unit 230 is preferably a heater rod 232 interpolated into the coating chamber 100 and rotating in an extension direction, and a reflector 233 reflecting heat of the heater rod 232 to the entire inside of the coating chamber 100. In addition, the pretreatment unit 200 preferably further includes the vaporization unit 220 that exists separately from the coating chamber 100, vaporizes the pretreatment material by applying heat to the pretreatment material, and injects the vaporized pretreatment material into the coating chamber 100.

At this time, the heater rod 232 extends to the outside of one surface of the coating chamber 100, and an extended part is preferably connected to an actuator controlled by the control unit 300 so that the rotation speed is controlled by the control unit 300. The reflector 233 may reflect heat, and is attached to the inner surface of the coating chamber 100 at a position closest to the heater rod 232 so that the heat dissipated from the heater rod 232 is transferred to the entire inside of the coating chamber 100.

Furthermore, the pretreatment unit 200 further includes a rotation unit 234 interpolated into the coating chamber 100 and coupled to the base material to rotate the base material, and the rotation unit 234 preferably includes a rotation plate 234a to which the base material is coupled and a rotation shaft rotating the rotation plate 234a. By including the rotation unit 234, even if the heater 231 applies heat in one direction at a fixed position, heat treatment may be performed evenly on the entire surface of the base material.

In more detail, in a state where the inside of the coating chamber 100 is maintained in the vacuum state, preferably, the pretreatment solution is vaporized by the vaporization unit 220 and introduced into the coating chamber 100, the inside of the coating chamber 100 may be heated by the heater 231 and the reflector 233, the pretreatment material may be deposited on the surface of the base material by rotating the base material by the rotation unit 234, after deposition is completed, the inside air of the coating chamber 100 is introduced into the trap apparatus 500 by opening the vacuum release valve and the main valve 120, and the trap apparatus 500 collects the remaining pretreatment material in the vaporized state. Accordingly, the remaining pretreatment material inside the coating chamber 100 may be removed. Thereafter, preferably, the coating material in the vaporized state is applied in the coating chamber 100 and is coated on the surface of the base material.

By adopting the second embodiment of the adhesion improvement pretreatment system 1000 of the present invention, it is possible to perform both the pretreatment process and the coating process in one chamber, thereby increasing the efficiency of space and reducing the cost required for equipment.

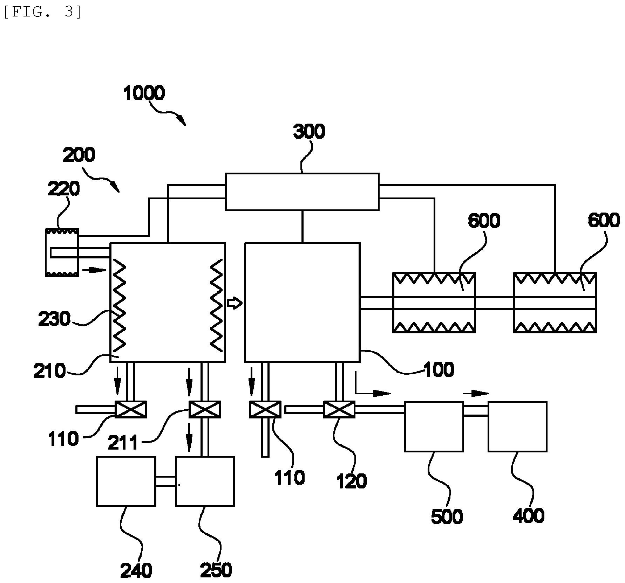

Hereinafter, a third embodiment of the adhesion improvement pretreatment system 1000 of the present invention will be described with reference to FIG. 3.

In the third embodiment of the adhesion improvement pretreatment system 1000 of the present invention shown in FIG. 3, the pretreatment unit 200? pretreatment chamber 210 is provided independently outside the coating chamber 100, and the pretreatment chamber 210 preferably has the heating unit 230 embedded therein. In addition, the pretreatment unit 200 preferably further includes the vaporization unit 220 provided on the outside the coating chamber 100, vaporizing the pretreatment material by applying heat to the pretreatment material, and injecting the vaporized pretreatment material into the coating chamber 100. At this time, the heating unit 230 may be the heater 231 attached to the inner surface or the outer surface of the pretreatment chamber 210, or may be the heater rod 232 interpolated into the pretreatment chamber 210 and rotated, and the reflector 233 reflecting heat of the heater rod 232. Furthermore, when the heating unit 230 is the heater rod 232, the pretreatment chamber 210 may further include the rotation plate 234a rotating the base material therein.

In addition, the pretreatment unit 200 preferably includes a pretreatment vacuum pump 240 maintaining the inside of the pretreatment chamber 210 in the vacuum state by sucking the inside air of the pretreatment chamber 210, and a pretreatment trap apparatus 250 disposed between the pretreatment vacuum pump 240 and the pretreatment chamber 210 and collecting the pretreatment material in the inside air of the pretreatment chamber 210. At this time, the pretreatment chamber 210 may include a pretreatment main valve 211 provided on a flow path connected to the pretreatment vacuum pump 240 and the pretreatment trap apparatus 250. The pretreatment main valve 211 may be controlled by the control unit 300, may be a ball valve type, and may be driven by receiving power.

In addition, the pretreatment chamber 210 may further include a vacuum release valve 110 releasing an internal vacuum by injecting outside air. The vacuum release valve 110 may be controlled by the control unit 300, and the control unit 300 may open the vacuum release valve 110 when releasing the vacuum in the coating chamber 100. The vacuum release valve 110 may be a solenoid type and may be actuated by receiving power.

More specifically, in a state where the inside of the pretreatment chamber 210 is maintained in a vacuum state, the pretreatment solution may be vaporized by the vaporization unit 220 and introduced into the pretreatment chamber 210, the heating unit 230 may deposit the pretreatment material on the surface of the base material by heating the base material, and after deposition is completed, transfer the base material in the pretreatment chamber 210 to the inside of the coating chamber 100 to perform a coating process. At this time, preferably, the coating material in the vaporized state is applied in the coating chamber 100 and is coated on the surface of the base material.

By adopting the third embodiment of the adhesion improvement pretreatment system 1000 of the present invention, the waiting time for treating the remaining pretreatment material in a chamber after the pretreatment process may be reduced by separating chambers performing the pretreatment process and the coating process, thereby increasing efficiency in terms of production time.

Hereinafter, the control unit 300 of the present invention will be described in more detail.

As described above, the control unit 300 of the present invention may adjust the condition of pretreatment according to the material of the base material (whether or not there is pretreatment, whether or not the pretreatment solution is vaporized, whether or not heat treatment is performed during pretreatment or coating, etc.) In more detail, the control unit 300 may receive material information of the base material, and analyze the material information of the base material to determine whether or not there is pretreatment, whether or not the pretreatment solution is vaporized, whether or not heat treatment is performed during pretreatment or coating, etc. Accordingly, the control unit 300 may determine whether to drive the heating unit 230 and the vaporization unit 220 of the pretreatment unit 200.

Furthermore, when the surface of the base material is made of two or more different types of materials, and whether or not there is pretreatment and whether or not the pretreatment solution is vaporized for each material are different, the control unit 300 may increase the deposition efficiency by driving the vaporization unit 220 to vaporize the pretreatment solution, and then actuate the heating unit 230, thereby making it possible to easily deposit a material having low adhesion to the vaporized pretreatment material or the pretreatment material, and may perform pretreatment even on a material that does not require pretreatment, thereby further increasing the adhesion. Depending on the pretreatment solution, the adhesion of the surface of the base material may be improved with maximum efficiency.

In addition, the control unit 300 of the present invention may control the main valve 120 or the vacuum release valve 110 to open or close. In more detail, the adhesion improvement pretreatment system 1000 of the present invention further includes a vacuum sensor 700 attached to at least one of the coating chamber 100 and the pretreatment chamber 210, and measuring a degree of internal vacuum of any one of the coating chamber 100 or the pretreatment chamber 210, and the control unit 300 may control the main valve 120 or the vacuum release valve 110 by receiving information from the vacuum sensor 700.

When the degree of vacuum measured by the vacuum sensor 700 is less than a vacuum control range, the control unit 300 preferably closes the vacuum release valve 110 of the coating chamber or the pretreatment vacuum release valve 110 of the pretreatment chamber 210, and actuates at least one of the vacuum pump 400 or the pretreatment vacuum pump 240. At this time, the vacuum control range is preferably 1000 Torr to 100 mTorr.

In addition, the control unit 300 further includes a temperature sensor attached to at least one of the coating chamber 100 or the pretreatment chamber 210, and measuring the internal temperature of any one of the coating chamber 100 or the pretreatment chamber 210, and preferably drives the heating unit 230 when the temperature measured by the temperature sensor is less than a predetermined numerical value. At this time, a temperature control range is preferably within 200 degrees Celsius.

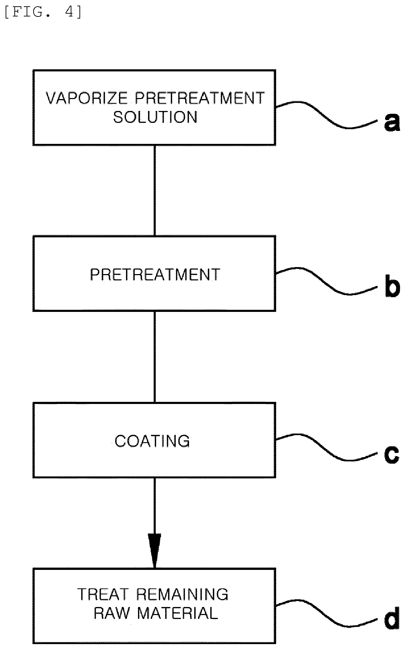

Hereinafter, an adhesion improvement pretreatment method of the present invention will be described with reference to FIG. 4.

As shown in FIG. 4, the adhesion improvement pretreatment method using the adhesion improvement pretreatment system of the present invention preferably includes, by the control unit 300, (a) vaporizing the pretreatment material by applying heat to the pretreatment material through the vaporization unit 220 of the pretreatment unit 200, (b) pretreating the base material by applying the pretreatment material to the surface of the base material through the pretreatment unit 200, (c) vacuum adsorbing the coating material and the base material through the coating chamber 100, and (d) receiving and treating the remaining coating material from the coating chamber 100 through the raw material treatment unit 600. At this time, steps (a) and (b) may be omitted depending on the material of the base material.

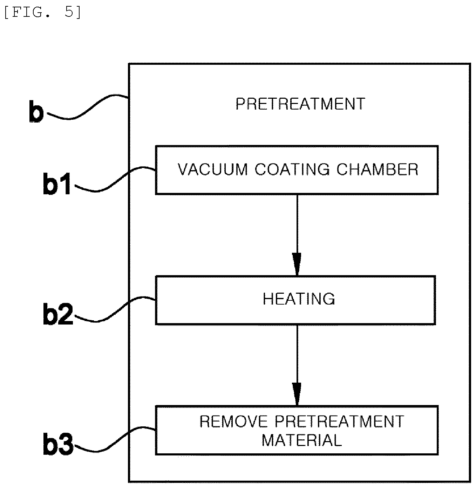

Hereinafter, a first embodiment of the adhesion improvement pretreatment method of the present invention will be described with reference to FIG. 5.

The first embodiment of the adhesion improvement pretreatment method of the present invention is preferably applied when the first and second embodiments of the adhesion improvement pretreatment system 1000 of the present invention are used. In more detail, the form of the adhesion improvement pretreatment system 1000 for performing the first embodiment of the adhesion improvement pretreatment method of the present invention is preferably that the pretreatment chamber 210 is integrally formed with the coating chamber 100, and the heating unit 230 is the heater 231 attached to the inner surface or the outer surface of the coating chamber 100 and directly applying heat to the coating chamber 100, or is the heater rod 232 and the reflector 233 interpolated into the coating chamber 100. In addition, the adhesion improvement pretreatment system 1000 preferably further includes the vaporization unit 220 that exists separately from the coating chamber 100, vaporizes the pretreatment material by applying heat to the pretreatment material, and injects the vaporized pretreatment material into the coating chamber 100.

Accordingly, the first embodiment of the adhesion improvement pretreatment method of the present invention preferably includes, as shown in FIG. 5, by the control unit 300, (b1) closing the vacuum release valve 110 and actuating the vacuum pump 400 to make the inside of the coating chamber 100 in the vacuum state, (b2) driving the heating unit 230 and applying heat to the coating chamber 100, and (b3) removing the remaining pretreatment material inside the coating chamber 100. At this time, step (b1) may be performed before step (a).

More specifically, step (b3) is preferably performed in that the control unit 300 opens the vacuum release valve 110 and the main valve 120 to allow the inside air of the coating chamber 100 to flow into the trap apparatus 500, and then the trap apparatus 500 collects the remaining pretreatment material in the vaporized state. At this time, the trap apparatus 500 may collect the remaining pretreatment material by instantaneously cooling the pretreatment solution including oil below a predetermined temperature therein.

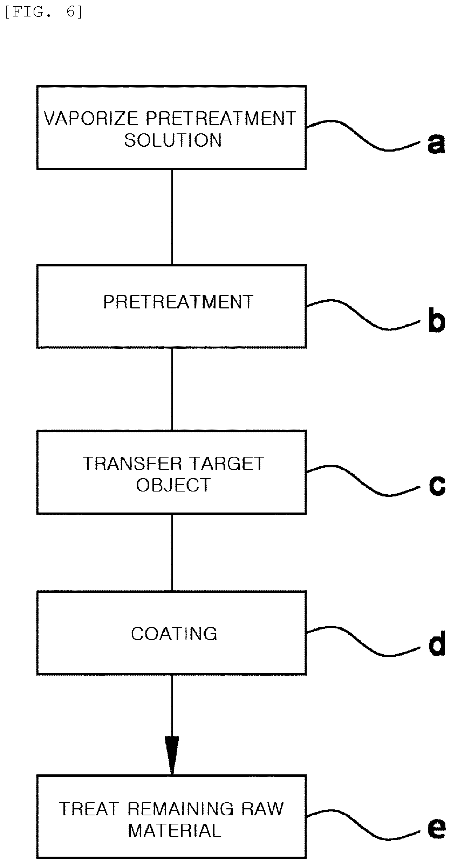

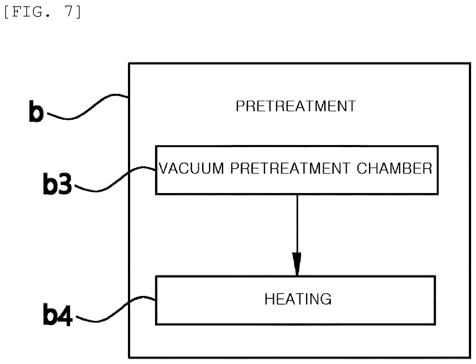

Hereinafter, a second embodiment of the adhesion improvement pretreatment method of the present invention will be described in more detail with reference to FIGS. 6 and 7.

The second embodiment of the adhesion improvement pretreatment method of the present invention is preferably applied when the third embodiment of the adhesion improvement pretreatment system 1000 of the present invention described above is used. In more detail, the form of the adhesion improvement pretreatment system 1000 for performing the first embodiment of the adhesion improvement pretreatment method of the present invention is preferably that the pretreatment chamber 210 is formed separately from the coating chamber 100, and the heating unit 230 is the heater 231 attached to the inner surface or the outer surface of the pretreatment chamber 210 and directly applying heat to the pretreatment chamber 210, or is the heater rod 232 and the reflector 233 interpolated into the pretreatment chamber 210. In addition, the adhesion improvement pretreatment system 1000 preferably further includes the vaporization unit 220 that exists separately from the pretreatment chamber 210, vaporizes the pretreatment material by applying heat to the pretreatment material, and injects the vaporized pretreatment material into the coating chamber 100.

Accordingly, the second embodiment of the adhesion improvement pretreatment method of the present invention preferably further includes, as shown in FIG. 6, between steps (b) and (c), (e) base material transfer step of moving the base material inside the pretreatment chamber 210 into the coating chamber 100. In addition, as shown in FIG. 7, step (b) further includes (b4) closing the vacuum release valve 110 and actuating the pretreatment vacuum pump 240 to make the inside of the pretreatment chamber 210 in the vacuum state and (b5) applying heat to the pretreatment chamber 210 by driving the heating unit 230. At this time, step (b4) may be performed before step (a).

Technical ideas should not be interpreted as being limited to the above-described embodiments of the present invention. Not only the scope of application is diverse, but also various modifications and implementations are possible at the level of those skilled in the art without departing from the gist of the present invention claimed in the claims. Therefore, such improvements and changes fall within the protection scope of the present invention as long as they are obvious to those skilled in the art.

### [Description of reference numerals]

1000: Adhesion improvement pretreatment system
100: coating chamber
110: vacuum release valve
120: main valve
200: pretreatment unit
210: pretreatment chamber
211: pretreatment main valve
220: vaporization unit
230: heating unit
231: heater
232: heater rod
233: reflector
234: rotation unit
234a: rotation plate
240: pretreatment vacuum pump
250: pretreatment trap apparatus
300: control unit
400: vacuum pump
500: trap apparatus
600: raw material treatment unit
700: vacuum sensor

## Claims

1. An adhesion improvement pretreatment system comprising: a coating chamber in which a space is formed therein, and a coating material is coated on a surface by applying heat and vacuum to a base material;
a pretreatment unit increasing an adhesion of the surface of the base material by applying a pretreatment material that increases the adhesion to the surface of the base material;
a vacuum pump maintaining an inside of the coating chamber in a vacuum state by sucking inside air of the coating chamber;
a trap apparatus disposed between the vacuum pump and the coating chamber and collecting at least one of a pretreatment material and the coating material in the inside air; and
a control unit controlling at least one of the coating chamber or the pretreatment unit.

2. The adhesion improvement pretreatment system of claim 1, wherein the pretreatment unit includes
a pretreatment chamber in which a space is formed therein, the pretreatment material is coated on the surface of the base material, and integrally formed with the coating chamber; and
a heating unit increasing an adhesion between the pretreatment material and the surface of the base material by applying heat to the base material.

3. The adhesion improvement pretreatment system of claim 2,
wherein the pretreatment chamber is formed integrally with the coating chamber,
wherein the heating unit includes a heater attached to an inner surface or an outer surface of the coating chamber and directly applying heat to the coating chamber.

4. The adhesion improvement pretreatment system of claim 2,
wherein the pretreatment chamber is formed integrally with the coating chamber,
wherein the heating unit includes
a heater rod interpolated into the coating chamber and rotating in an extension direction; and
a reflector reflecting heat of the heater rod to the entire inside of the coating chamber.

5. The adhesion improvement pretreatment system of claim 4, wherein the pretreatment unit further includes a rotation unit interpolated into the coating chamber and coupled to the base material to rotate the base material, and
the rotation unit includes a rotation plate to which the base material is coupled and a rotation shaft rotating the rotation plate.

6. The adhesion improvement pretreatment system of claim 2,
wherein the pretreatment chamber is formed integrally with the coating chamber,
wherein the pretreatment unit further includes a vaporization unit that exists separately from the coating chamber, vaporizes the pretreatment material by applying heat to the pretreatment material, and injects the vaporized pretreatment material into the coating chamber.

7. The adhesion improvement pretreatment system of claim 2, wherein the pretreatment chamber is provided independently outside the coating chamber, and has the heating unit embedded therein.

8. The adhesion improvement pretreatment system of claim 7, wherein the pretreatment unit further includes a vaporization unit provided on the outside the coating chamber, vaporizing the pretreatment material by applying heat to the pretreatment material, and injecting the vaporized pretreatment material into the coating chamber.

9. The adhesion improvement pretreatment system of claim 2, further comprising: a vacuum sensor attached to at least one of the coating chamber and the pretreatment chamber, and measuring a degree of internal vacuum of any one of the coating chamber or the pretreatment chamber,
wherein each of the coating chamber and the pretreatment chamber includes a vacuum release valve injecting outside air into the inside, and
when the degree of vacuum measured by the vacuum sensor is less than a predetermined numeral value, the control unit closes the vacuum release valve, and actuates at least one of the vacuum pump or the pretreatment vacuum pump.

10. The adhesion improvement pretreatment system of claim 2, further comprising: a temperature sensor attached to at least one of the coating chamber or the pretreatment chamber and measuring an internal temperature of any one of the coating chamber or the pretreatment chamber,
wherein when the temperature measured by the temperature sensor is less than a predetermined numerical value, the control unit drives the heating unit.

11. The adhesion improvement pretreatment system of claim 1, further comprising: a raw material treatment unit connected to the coating chamber, receiving the coating material from the coating chamber, and decomposing and treating the coating material.

12. An adhesion improvement pretreatment method using an adhesion improvement pretreatment system, the adhesion improvement pretreatment method comprising:, by a control unit,
(a) vaporizing a pretreatment material by applying heat to a pretreatment material through a vaporization unit of a pretreatment unit;
(b) pretreating a base material by applying the pretreatment material to a surface of the base material through the pretreatment unit;
(c) vacuum adsorbing the coating material and the base material through a coating chamber; and
(d) receiving and treating a remaining coating material from the coating chamber through a raw material treatment unit.

13. The adhesion improvement pretreatment method of claim 12, wherein (b) includes, by the control unit,
(b1) closing a vacuum release valve and actuating a vacuum pump to make an inside the coating chamber in a vacuum state;
(b2) applying heat to the coating chamber by operating a heating unit; and
(b3) removing the remaining pretreatment material inside the coating chamber.

14. The adhesion improvement pretreatment method of claim 12, wherein step (b) includes, by the control unit,
(b4) closing a vacuum release valve and actuating a pretreatment vacuum pump to make an inside of a pretreatment chamber in a vacuum state; and
(b5) applying heat to the pretreatment chamber by driving a heating unit.

15. The adhesion improvement pretreatment method of claim 14, further comprising: between step (b) and step (c), (e) base material transfer step of moving the base material inside the pretreatment chamber into the coating chamber.
